Europäisches Patentamt

European Patent Office

Office européen des brevets

(11) Publication number: **0 160 418**
**B1**

(12) **EUROPEAN PATENT SPECIFICATION**

(45) Date of publication of patent specification: 25.07.90

(51) Int. Cl.⁵: **H 05 K 1/03**

(21) Application number: 85302368.7

(22) Date of filing: 03.04.85

(54) **Printed circuit board.**

(30) Priority: 10.04.84 JP 72472/84

(43) Date of publication of application:
06.11.85 Bulletin 85/45

(45) Publication of the grant of the patent:
25.07.90 Bulletin 90/30

(84) Designated Contracting States:
DE FR GB

(56) References cited:
EP-A-0 090 696
DE-A-2 945 191
US-A-3 136 680
US-A-4 236 952
US-A-4 335 180

(73) Proprietor: JUNKOSHA CO. LTD.
25-25, Miyasaka 2-chome
Setagaya-ku Tokyo 156 (JP)

(72) Inventor: Suzuki, Hirosuke
21-8, Kotesashi-machi 4-chome
Tokorozawa-shi Saitama (JP)

(74) Representative: Taylor, Derek George et al
MATHISEN, MACARA & CO. The Coach House
6-8 Swakeleys Road
Ickenham Uxbridge UB10 8BZ (GB)

Courier Press, Leamington Spa, England.

## Description

The invention relates to a printed circuit board. In particular the invention can provide a printed circuit board for transmission of electrical signals at high frequencies, which has a small coefficient of thermal deformation, including thermal expansion and contraction.

There is a conventional printed circuit board commercially available having a small coefficient of thermal deformation which is formed by pasting copper foil on the outer surface of an insulating layer of fiberglass fabric containing polytetrafluoroethylene (PTFE). However, this conventional printed circuit board has a dielectric loss factor which can be as large as about 0.002 at 10 GHz, and is not often used as a printed circuit board for high frequencies.

A printed circuit board having a high specific permittivity has been proposed, which is formed by pasting copper foil on the outer surface of an insulating layer of PTFE in which a filler consisting of titanium oxide powder or alumina (aluminum oxide powder) is mixed. However, this printed circuit board has a thermal expansion coefficient with respect to its surface direction and thickness direction of as much as $1 \times 10^{-4}/°C$. Obviously, it is thermally unstable and is preferably not used.

It is also known from US-A-3,136,680 to provide a printed circuit board comprising a laminate having outer surfaces of solid, sintered, non-porous polytetrafluoroethylene (PTFE) and a metallic layer bonded to each of said outer surfaces by a bonding agent.

A requirement exists for a printed circuit board which avoids a great increase in the thermal expansion coefficient, even if a filler is mixed therein for the purpose of increasing the specific permittivity to a high level, and which has excellent properties in a high-frequency transmission region.

According to the present invention there is provided a printed circuit board comprising a laminate having outer surfaces of solid, sintered, non-porous polytetrafluoroethylene (PTFE) and a metallic layer bonded to each of said outer surfaces by a bonding agent characterised in that the laminate comprises two layers of solid sintered non-porous PTFE and a central layer of porous expanded PTFE sandwiched therebetween, and said bonding agent is perfluoroalkyl-ether copolymer (PFA) or tetrafluoroethylene-hexafluoropropylene copolymer (FEP). The solid PTFE layers may contain fibers of expanded porous PTFE.

The PTFE layers may contain a filler such as titanium dioxide powder or aluminum oxide powder. The layer of expanded, porous PTFE may be a cloth woven of fibers of expanded, porous PTFE, or it may be a layer of expanded, porous PTFE film.

The invention will now be particularly described, by way of example, with reference to the accompanying drawings in which:

Figure 1 is a schematic view, partly in cross-section, showing a printed circuit board which was formulated to overcome the problems referred to above, but forms no part of the present invention.

Figures 2 and 3 are cross sectional views of embodiments of printed circuit boards according to the invention.

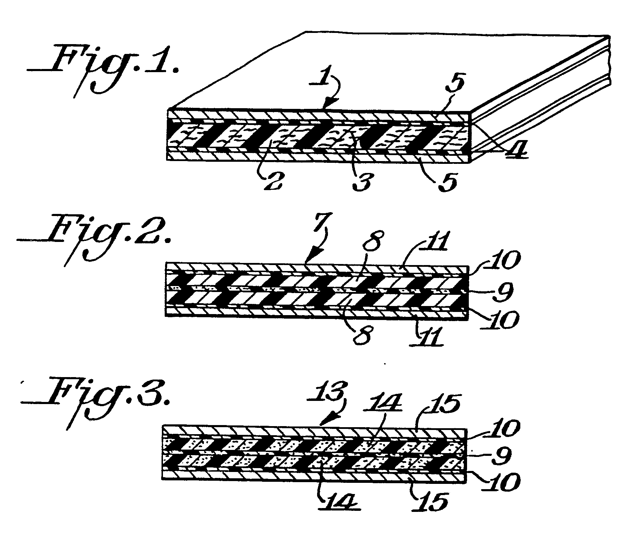

Figure 1 is a schematic diagram of a section of a printed circuit board 1 in which layers of copper foil 5 are bonded to both surfaces of a solid PTFE layer 3 in which expanded, porous PTFE fibers 2 are mixed, using bonding agent 4, and this printed circuit board formed into an etched circuit pattern, not shown, by conventional techniques.

The expanded porous PTFE fiber 2 referred to above is manufactured by, for example, a method disclosed in U.S. Patent 3,953,566.

A printed circuit board, of the construction shown in Figure 1, having a thickness of 0.6 mm was formed by extrusion-moulding PTFE in which 10% by weight of sintered, expanded, porous PTFE fiber which had been stretched 10 times its original length and which consisted or fiber pieces 10 µm in thickness and 5 mm in length were mixed. The resultant product was sintered to obtain a layer of sintered, solid PTFE 3. To both surfaces of the layer 3 were attached layers of 10 µm thickness of a thermoplastic bonding agent 4 consisting of a layer of polytetrafluoroethylene-perfluoroalkyl vinyl ether copolymer (PFA) or a tetrafluoroethylenehexafluoropropylene copolymer (FEP). To the outer surfaces of the layers 4 were attached layers of 35 µm thickness of copper foil or aluminum foil. The resultant product was heated so as to unite all of the layers. The properties of this printed cirtcuit were measured. Good results were obtained, i.e. the dielectric loss factor and the thermal expansion coefficient with respect to the surface direction thereof were $1 \times 10^{-4}$ and $1 \times 10^{-5}$, respectively.

Because the porous PTFE material layer is provided along the layer of solid PTFE, the pores in the former, the high-frequency characteristics of which are superior to those of the latter, work as heat insulators and stress resistors and substantially prevent a great increase in the thermal expansion coefficient of this board. Therefore, a printed circuit board having a small thermal expansion coefficient and excellent high-frequency characteristics can be provided.

A modification of the circuit board of Figure 1, and which constitutes one embodiment of the present invention, is seen in Figure 2. In this printed circuit board 7, a layer of 5 µm in thickness of sintered, expanded, porous PTFE 9 is sandwiched between two layers of sintered solid PTFE 8, and layers of conductive metal foil 11 consisting of copper foil or aluminum foil are attached to the outermost surfaces of the layers 8 by layers 10 of the bonding agent.

It was ascertained that the printed circuit board 7 in this embodiment had essentially the same properties as the printed circuit board 1 in Figure 1.

Figure 3 shows a modified example of the embodiment of Figure 2. In this example, about 15 percent by weight of titanium oxide powder, for example, titanium dioxide ($TiO_2$) powder, to increase the specific permittivity,. is mixed into the layers of solid PTFE 14 which are laminated on to both surfaces of a layer of porous, expanded PTFE 9, as shown.

Titanium dioxide powder having a specific permittivity in the range of 2.2 to 10 is suitable for this purpose.

In this embodiment, 18 µm thick copper foil is used as the conductive metal foil 15, and this embodiment also has excellent characteristics.

According to a further embodiment of the present invention, catalyst layers in which plating medium nuclei are dispersed, are provided on the outer surfaces of the solid PTFE layers. For example, palladium salt is dispersed in these catalyst layers. These catalyst layers may be formed so that the nuclei of the plating catalyst are dispersed in the surface portion of the printed circuit board as a whole, or so that the nuclei of the plating catalyst are formed in the shape of a circuit pattern by an optical reaction. In the latter case, a circuit pattern can be obtained easily by carrying out a conventional chemical copper-plating operation. In the former case, a conductive circuit pattern is obtained by providing through holes, through which the circuit elements are fastened, in a printed circuit board, permanently masking the non-circuit portions, subjecting the circuit portion to a surface treatment so that a plating operation can be carried out smoothly, and then immersing the resultant product in a chemical copper-plating liquid so as to be plated therewith.

By the present invention a printed circuit board is provided having an insulating layer which contains porous, expanded PTFE material and which extends along a layer of solid PTFE, the layer of solid PTFE having excellent high-frequency transmission characteristics and the porous, expanded PTFE material having excellent high-frequency transmission characteristics and, in addition, excellent heat-insulating characteristics and stress-resisting capability. Therefore, a printed circuit board having excellent high-frequency transmission characteristics and a small thermal expansion coefficient can be obtained.

## Claims

1. A printed circuit board comprising a laminate having outer surfaces of solid, sintered, non-porous polytetrafluoroethylene (PTFE) and a metallic layer bonded to each of said outer surfaces by a bonding agent characterised in that the laminate comprises two layers of solid sintered non-porous PTFE and a central layer of porous expanded PTFE sandwiched therebetween, and said bonding agent is perfluoroalkyl-ether copolymer (PFA) or tetrafluoroethylene-hexafluoropropylene copolymer (FEP).

2. A printed circuit board according to claim 1 characterised in that said solid PTFE layers contain fibers of expanded porous PTFE.

3. A printed circuit board according to claim 2 characterised in that said fibers are sintered.

## Patentansprüche

1. Leiterplatte enthaltend ein Schichtgebilde mit äußeren Oberflächen aus festem, gesinterten, nicht porösen Polytetrafluorethylen (PTFE) und mit einer metallischen Lage, die mit jeder der besagten äußeren Oberflächen durch ein Bindemittel verbunden ist, dadurch gekennzeichnet, daß das Schichtgebilde zwei Lagen festes, gesintertes, nicht poröses PTFE und eine mittige Lage aus porösem, gestrecktem PTFE, die dazwischen sandwichartig eingebracht ist, enthält, und daß das besagte Bindemittel ein Perfluoralkylethercopolymer (PFA) oder ein Tetrafluorethylen-hexafluorpropylen-copolymer (FEP) ist.

2. Leiterplatte nach Anspruch 1, ist dadurch gekennzeichnet, daß die besagten festen PTFE-Lagen Fasern aus expandiertem, porösen PTFE enthalten.

3. Eine Leiterplatte nach Anspruch 2, dadurch gekennzeichnet, daß die besagten Fasern gesintert sind.

## Revendications

1. Une plaquette de circuit imprimé comprenant un stratifié ayant des surfaces extérieures en polytétrafluoroéthylène (PTFE) non poreux, fritté, solide et une couche métallique liée à chacune desdites surfaces extérieures par un agent de liaison, caractérisée en ce que le stratifié comprend deux couches de PTFE non poreux, fritté, solide et une couche centrale de PTFE expansé, poreux, prise en sandwich entre ces deux couches, et ledit agent de liaison est un copolymère de perfluoroalkyléther (PFA) ou un copolymère de tétrafluoroéthylène-hexafluoropropylène (FEP).

2. Une plaquette de circuit imprimé selon la revendication 1, caractérisée en ce que lesdites couches de PTFE solide contiennent des fibres de PTFE poreux expansé.

3. Une plaquette de circuit imprimé selon la revendication 2, caractérisée en ce que lesdites fibres sont frittées.

*Fig.1.*

*Fig.2.*

*Fig.3.*